# EUROPEAN PATENT APPLICATION

(11) **EP 1 555 866 A2**
(43) Date of publication of application: **20.07.2005**
(21) Application number: 05250183.0
(22) Date of filing: 14.01.2005
(51) Int. Cl.: H05K 7/18

(54) **Universal connector for mounting a telescoping slide rail assembly in a rack**

(30) Priority: 16.01.2004 US 537435 P
(71) Applicant: Pentair Electronic Packaging Co., Des Plaines, IL 60018 (US)
(72) Inventor: Dubon, William, Bloomingdale, Illinois 60108 (US); Stephens, Ronan, Berwyn, Illinois 60402 (US); Anderson, Donald, Oak Park, Illinois 60302 (US)
(74) Representative: W.P. Thompson & Co.

(57) **Abstract**

A universal connector including a first element operatively coupled to a second element for relative movement. Each of the first and second elements includes a base and a pair of opposing arms that each have a first connector and a second connector such the first connectors are oriented toward a first side and the second connectors are oriented toward a second side. An elongated projection extends from the first base to a platform and a pair of legs extending from the platform to define a first receptacle. A pair of legs extend from the second base defining a second receptacle. The second receptacle is configured to receive the first element pair of legs and a portion of the projection.

## Description

### BACKGROUND

[001] The present invention relates generally to mounting a telescoping slide rail assembly in a rack and more specifically to a universal connector that facilitates mounting the telescoping sliding rail assembly in racks having various different engagement apertures.

[002] A typical server rack includes two pairs of uprights disposed to define opposing sides of the rack that may be disposed within a housing or cabinet. A server or other electronic or telecommunication device is connected to opposing telescoping slide rail assemblies. The server may move between a fully retracted position disposed within the rack, and a fully extended position disposed substantially outside the rack. The fully extended position facilitates servicing of the server.

[003] Under existing manufacturing specifications, the uprights of the rack include a plurality of vertically aligned apertures formed along a longitudinal extent thereof. Presently, the apertures are configured to have one of two configurations. A user must purchase a specific type of telescoping slide rail assembly based on the whether the rack apertures have a square hole configuration or a round hole configuration. Accordingly, telescoping slide rail assembly manufacturers must make telescoping slide rail assemblies commercially available that are compatible with the square hole configuration and the round hole configuration of the various available racks.

**[004]** One telescoping slide rail assembly includes a connector with several tabs having a rectangular configuration. The rectangular tabs engage the corresponding square hole configuration of the appropriate rack for secure engagement thereof.

[005] Another telescoping slide rail assembly includes a connector with several tabs having a cylindrical configuration. The cylindrical tabs engage the corresponding round hole configuration of the appropriate rack for secure engagement thereof. Usually, the round hole configuration requires use of at least four screws per bracket to secure the telescoping slide rail assembly to the rack. With two pairs of uprights, a user is required to install sixteen screws to mount one server.

[006] A further disadvantage of prior devices is that an end user cannot purchase all its telescoping slide rail assemblies with either the tabs having a rectangular configuration or the cylindrical configuration because the rack manufacturer specifications are not consistent with respect to telescoping slide rail assembly mounting specifications. As a result, suppliers of telescoping slide rail assemblies must manufacture and sell both versions. This not only increases production costs by requiring the manufacture of two separate types of telescoping slide rail assemblies, but also limits an end user to having to order one particular type of telescoping slide rail assembly.

**[007]** Therefore, there exists a need for a universal connector capable of facilitating mounting of a telescoping slide rail assembly to a server rack independent of the rack manufacturer mounting aperture specifications.

### BRIEF DESCRIPTION OF THE DRAWINGS

**[008]** Certain embodiments are shown in the drawings by way of example. It is to be understood that the present disclosure is not limited to the arrangements and instrumentality shown in the attached drawings, wherein:
FIG. 1 illustrates a perspective view of a universal connector;
FIG. 2 illustrates an exploded view of the universal connector of FIG. 1;
FIG. 3 illustrates an elevation view of the universal connector of FIG. 1;
FIG. 4 illustrates an elevation view of the universal connector of FIG. 1 engaging a telescoping slide rail assembly and one embodiment of an upright with first connectors;
FIG. 5 illustrates an end view of the universal connector of FIG. 4 engaging the telescoping slide rail assembly with the first connectors;
FIG. 6 illustrates an elevation view of the universal connector of FIG. 1 engaging the telescoping slide rail assembly and another embodiment of the upright with second connectors; and
FIG. 7 illustrates an end view of the universal connector of FIG. 6 engaging the telescoping slide rail assembly with the second connectors.

### DETAILED DESCRIPTION

**[009]** For the purposes of promoting and understanding the principles disclosed herein, reference will now be made to the preferred embodiments illustrated in the drawings and specific language will be used to describe the same. It will nevertheless be understood that no limitation of the scope is thereby intended. Such alterations and further modifications in the illustrated device and such further applications are the principles disclosed as illustrated therein as being contemplated as would normally occur to one skilled in the art to which this disclosure relates.

**[010]** In one principle aspect of the present disclosure, a universal connector including a first element operatively coupled to a second element for relative movement. Each of the first and second elements includes a base and a pair of opposing arms that each have a first connector and a second connector such the first connectors are oriented toward a first side and the second connectors are oriented toward a second side. An elongated projection extends from the first base to a platform and a pair of legs extending from the platform to define a first receptacle. A pair of legs extend from the second base defining a second receptacle. The second receptacle is configured to receive the first element pair of legs and a portion of the projection.

**[011]** In another principle aspect of the present disclosure, a universal connection assembly includes a telescoping slide rail assembly and a pair of universal connectors. The telescoping slide rail assembly includes a stationary slide rail having a pair of flanges operatively coupled adjacent opposing ends thereof. The flanges each have a plurality of apertures formed therein. Each of the universal connectors a first element operatively coupled to a second element for relative movement. Each of first and second elements includes a base and a pair of opposing arms that each have a first connector and a second connector such the first connectors are oriented toward a first side and the second connectors are oriented toward a second side. An elongated projection extends from the first base to a platform and a pair of legs extending from the platform to define a first receptacle. A pair of legs extend from the second base defining a second receptacle. The second receptacle is configured to receive the first element pair of legs and a portion of the projection. One of the first connectors and the second connectors of each universal connector engages one of the at least a pair of the flange apertures to facilitate operative coupling of the telescoping slide rail assembly to a rack.

[012] The universal connector facilitates mounting a single telescoping slide rail assembly, including a mounting flange, to a rack having a plurality of rectangular or cylindrical apertures.

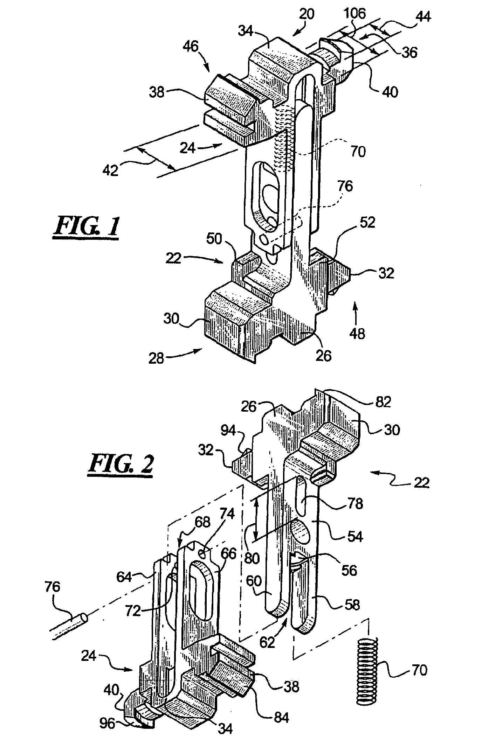

**[013]** FIG. 1 illustrates a perspective view of a universal connector 20 including a first element 22 operatively coupled to a second element 24 for relative movement. The first element 22 includes a base 26 and a pair of opposing arms 28. Each of the first opposing arms 28 includes a first connector 30 having a first configuration and a second connector 32 having a second configuration. The second element 24 includes a base 34 and a pair of opposing arms 36. Each of the second opposing arms 36 includes a first connector 38 having a first configuration and a second connector 40 having a second configuration.

**[014]** It is within the teachings of the present disclosure that the first configuration of the first connectors 30, 38 may be any suitable configuration to facilitate mounting of a telescoping rail assembly to a rack having apertures with a first configuration formed in uprights thereof. For example, in one embodiment, the configuration of the first connectors 30, 38 may have a generally polygon shape that facilitates connection with a generally polygon shaped aperture formed in the uprights of the rack.

**[015]** It is also within the teachings of the present disclosure that the second configuration of the second connectors 32, 40 may be any suitable configuration to facilitate connection of the telescoping slide rail assembly to the rack having apertures with a second configuration. For example, in one embodiment, the configuration of the second connectors 32, 40 may have a generally round shape that facilitates connection with a generally round apertures formed in the uprights of the rack.

**[016]** In one embodiment, the first connectors 30, 38 are configured to have a first width 42 that is greater than a second width 44 of the second connectors 32, 40. Such a configuration is advantageous in order to facilitate use of a single universal connector 20 to facilitate connection of telescoping slide assemblies to the uprights of racks regardless of the shape of the apertures formed in the uprights of the rack.

**[017]** The first connectors 30, 38 are both oriented toward a first side 46 and the second connectors 32, 40 are oriented toward a second side 48. It will be recognized by those of skill in the art that the pair of first connectors 30, 38 facilitate connection of the telescoping slide assembly to a rack with uprights having apertures of a first configuration and the second connectors 32, 40 cooperatively facilitate connection of the telescoping slide assembly to an upright of the rack having apertures with a second configuration.

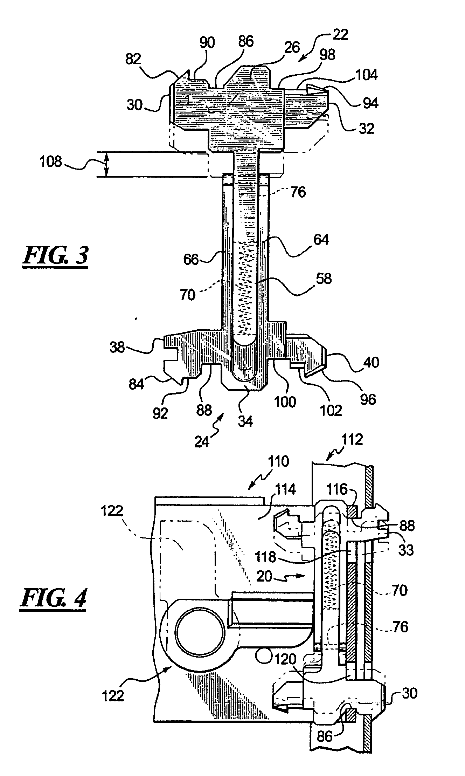

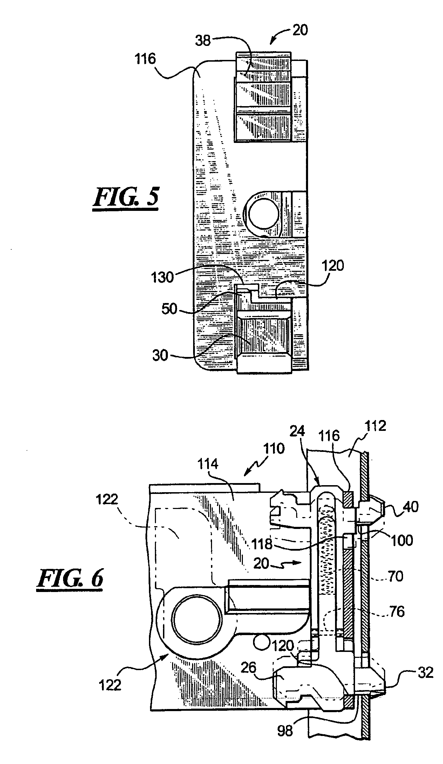

**[018]** The first element 22 further includes an indexing structure 50 to facilitate proper orientation of the pair of first connectors 30, 38 for engagement with a flange or other appropriate structure of the telescoping slide rail assembly, as may be seen in FIGs. 4 and 5. The indexing structure 50 is disposed contiguous with the base 26, the first connector 30 and a projection extending from the first base 26 as will be discussed in detail below.

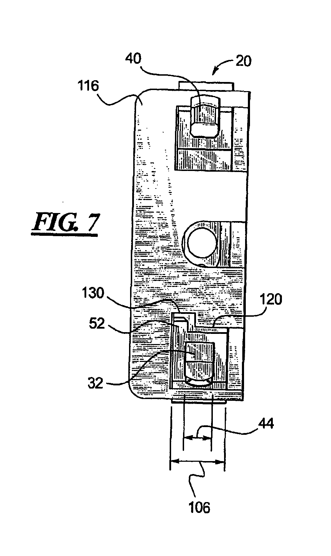

[019] The second element 24 further includes a second indexing structure 52 to facilitate proper orientation of the pair of second connectors 32, 40 for engagement with the flange or other appropriate structure of the telescoping side rail assembly, as may be seen in FIGS. 6 and 7. The second indexing structure 52 is disposed contiguous with the projection the second connector 32 and the base 26, as will be described in more detail below .

[020] It is within the teachings of the present disclosure that the first and second indexing structures 50, 52 may have any suitable configuration to facilitate engagement of the universal connector 20 with the flange of the telescoping slide rail assembly in only one correct orientation.

[021] FIG. 2 illustrates a perspective view and FIG. 3 illustrates an elevation view, both of the universal connector 20 of FIG. 1. The first element 22 further includes an elongated projection 54 extending from the first base 26 to a platform 56 and having a pair of legs 58, 60 extending from the platform 56 to define a first receptacle 62.

[022] The second element 24 further includes a pair of legs 64, 66 extending from the second base 34 to define a second receptacle 68. The second receptacle 68 is configured to receive the first element pair of legs 58, 60 and a portion of the projection 54. A biasing element 70 is disposed between the platform 56 and the second element base 34 to normally bias the first and second elements 22, 24 away from one another. The second element legs 64, 66 further include an aperture 72, 74 formed adjacent a distal and thereof in order to facilitate operatively coupling the second element legs 64, 66 with a fastener 76 that is received by an aperture 78 formed in the projection 54 to define an extent 80 of relative movement.

**[023]** The first configuration of the first connectors 30, 38 each includes a lead in ramp 82, 84 to facilitate ease of engagement of the universal connector 20 with the flange of the telescoping slide rail assembly as discussed in more detail below. Upon installation of the universal connector 20 to the flange of the telescoping slide rail assembly, the flange is disposed within a first install notch 86, 88 which thereby defines a first mounting surface 90, 92 between the first lead in ramp 82, 84 and the first install notch 86, 88. It will be recognized by those of skill in the art that the first mounting surface 90, 92 its connection of the telescoping slide rail assembly to the uprights of the rack, such that the first mounting surface as a depth sufficient to engage the thickness of the upright of the rack in a relatively close tolerance.

**[024]** The second configuration of the second connectors 32, 40 also includes a second lead in ramp 94, 96, a second install notch 98, 100 and a second mounting surface 102, 104 define between the second lead in ramp 94, 96, the second install notch 98, 100.

[025] It will be recognized by those of skill in the art that the second lead in ramp, second install notch and second mounting surface are configured and oriented to perform the substantially identical function as described above with respect to the first connectors, except that the second connectors facilitate mounting of the telescoping slide rail assembly with an upright of a rack having generally round apertures formed therein.

[026] The second configuration of the second connectors 32, 40 include a second install notch 98, 100 that has a first width 106 that is greater than a second width 44 of the second lead in ramp 94, 96 and a second mounting service 102, 104 to find between the second lead in ramp 94, 96 and the second install notch 98, 100.

**[027]** FIG. 3 further illustrates in fathom the extent of relative movement 108 between the first and second elements 22, 24.

[028] FIG. 4 illustrates an elevation view of the universal connector 20 of FIG. 1 engaging one embodiment of a telescoping slide rail assembly 110 and an upright 112 of the display rack with the first connectors 30, 38. The telescoping slide rail assembly 110 includes a stationery slide rail 114 that has a flange 116 operatively coupled adjacent each opposing end thereof. Only one end of the telescoping slide rail assembly 110 is shown in FIG. 4 for clarity. However, it will be recognized by those of skill in the art that the flange operatively coupled to the opposing end of the telescopic slide rail assembly 110 may be conventionally formed. The flanges 116 have a plurality of apertures 118, 120 formed therein. The universal connector 20 is configured as described above.

**[029]** To install the universal connector 20 in the flange 116 of the telescopic slide rail assembly 110, the first connector 30 is fitted through the aperture 120 such that the install notch 86 engages the aperture 120. The second element 24 may then be compressed slightly in the direction of the first element 22 so that the first connector 38 may be inserted through aperture 118 such that the install notch 88 engages the aperture 118. The biasing element forces the first and second elements 22, 24 away from one another such that the universal connector 20 is operatively coupled to the telescopic slide rail assembly 110. A lock 122, which is connected to the telescoping slide rail assembly 110 or the flange 116, is disposed adjacent the universal connector 20 and moveable between the first operative position, as may be seen in phantom in FIG. 4 in order to facilitate installation and removal of the universal connector 20 and a second operative position as may be seen in FIG. 4 that facilitates retention of the universal connector 20 with the telescopic slide rail assembly 110 and in more particularly, the flange 116.

[030] The telescoping slide rail assembly 110 with the installed universal connector 20 is not ready for installation into one of the uprights 112 of the rack. As discussed above, the universal connector 20 oriented as shown in FIGs. 4 and 5 is configured to engage an upright 112 which has a generally polygonal shape, commonly referred to as a square or rectangular shape.

[031] FIG. 5 illustrates an end view of the universal connector 20 installed in the flange 116 of the telescoping slide rail assembly. The first indexing structure engages a recess 130 defined in the aperture 120 such that the first connectors, 30, 38 are properly oriented with respect to the flange 116.

[032] FIG. 6 illustrates an elevation view of the universal connector 20 of FIG. 1 engaging another embodiment of the telescoping slide rail assembly 110 and upright 112 with the second connectors 32, 40. The telescoping slide rail assembly 110 includes a stationery slide rail 114 that has a flange 116 operatively coupled adjacent each opposing end thereof. Only one end of the telescoping slide rail assembly 110 is shown in FIG. 4 for clarity. However, it will be recognized by those of skill in the art that the flange is operatively coupled to the opposing end of the telescopic slide rail assembly 110 may be conventionally formed. The flanges 116 have a plurality of apertures 118, 120 formed therein. As described above, the apertures 118, 120 may be formed with a round or square configuration. The universal connector 20 is configured as described above.

[033] To install the universal connector 20 in the flange 116 of the telescopic slide rail assembly 110, the second connector 32 is fitted through the aperture 120 such that the install notch 98 engages the aperture 120. The second element 24 may then be compressed slightly in the direction of the first element 22 so that the second connector 40 may be inserted through aperture 118 such that the install notch 100 engages the aperture 118. The biasing element forces the first and second elements 22, 24 away from one another such that the universal connector 20 is operatively coupled to the telescopic slide rail assembly 110. A lock 122, which is connected to the telescoping slide rail assembly 110 or the flange 116, is disposed adjacent the universal connector 20 and moveable between the first operative position, as may be seen in phantom in FIG. 6 in order to facilitate installation and removal of the universal connector 20 and a second operative position as may be seen in FIG. 6 that facilitates retention of the universal connector 20 with the telescopic slide rail assembly 110 and in more particularly, the flange 116.

**[034]** The telescoping slide rail assembly 110 with the installed universal connector 20 is now ready for installation into one of the uprights 112 of the rack. As discussed above, the universal connector 20 oriented as shown in FIGS. 6 and 7 is configured to engage an upright 112 which has apertures with a generally round shape, commonly referred to as a circular shape.

**[035]** FIG. 7 illustrates an end view of the universal connector 20 installed in the flange 116 of the telescoping slide rail assembly. The second indexing structure engages a recess 130 defined in the aperture 120 such that the first connectors, 30, 38 are properly oriented with respect to the flange 116.

**[036]** As discussed above, the universal connector 100 allows for connection of the rail 102 to a server rack having apertures with either a square shape configuration and a circular shape configuration.

**[037]** Furthermore, while the particular preferred embodiments have been shown and described, it will be obvious to those skilled in the art that changes and modifications may be made without departing from the teaching of the disclosure. The matter set forth in the foregoing description and accompanying drawings is offered by way of illustration only and not as limitation. The actual scope of the disclosure is intended to be defined in the following claims when viewed in their proper perspective based on the related art.

## Claims

1. A universal connector comprising:
a first element operatively coupled to a second element for relative movement;
each of the first and second elements including a base and a pair of opposing arms;
each of the opposing arms including a first connector having a first configuration and a second connector having a second configuration such that the first connectors are oriented toward a first side and the second connectors are oriented toward a second side;
the first element further including an elongated projection extending from the first base to a platform and having a pair of legs extending from the platform to define a first receptacle;
the second element further including a pair of legs extending from the second base defining a second receptacle; and
the second receptacle configured to receive the first element pair of legs and a portion of the projection.

2. A universal connector as claimed in claim 1, wherein the second element legs include an aperture formed adjacent a distal end thereof in order to operatively couple the second element legs with a fastener that is received by an aperture formed in the projection to define an extent of relative movement.

3. A universal connector as claimed in claim 1 or 2, wherein the first element further includes a first indexing structure to facilitate proper orientation of the pair of first connectors.

4. A universal connector as claimed in claim 3, wherein the first indexing structure is disposed contiguous with the projection, the first connector and the base.

5. A universal connector as claimed in any one of the preceding claims, wherein the first element further includes a second indexing structure to facilitate proper orientation of the pair of second connectors.

6. A universal connector as claimed in claim 5, wherein the second indexing structure is disposed contiguous with the projection, the second connector and the base.

7. A universal connector as claimed in any one of the preceding claims, wherein the configuration of the first connector facilitates connection with a polygon-shaped aperture.

8. A universal connector as claimed in any one of the preceding claims, wherein the configuration of the second connector facilitates connection with a generally round aperture.

9. A universal connector as claimed in any one of the preceding claims, further including a biasing element disposed between the platform and the second element base.

10. A universal connector as claimed in any one of the preceding claims, wherein the first configuration of the first connectors includes a lead-in ramp.

11. A universal connector as claimed in any one of the preceding claims, wherein the first configuration of the first connectors includes a first install notch.

12. A universal connector as claimed in any one of the preceding claims, wherein the first configuration of the first connectors includes a first mounting surface defined between a first lead-in ramp and a first install notch.

13. A universal connector as claimed in any one of the preceding claims, wherein the first configuration of the first connectors has a first width that is greater than a second width of the second configuration of the second connectors.

14. A universal connector as claimed in any one of the preceding claims, wherein the second configuration of the second connectors includes a second lead-in ramp.

15. A universal connector as claimed in any one of the preceding claims, wherein the second configuration of the second connectors includes a second install notch.

16. A universal connector as claimed in any one of the preceding claims, wherein the second configuration of the second connectors includes a second mounting surface defined between a second lead-in ramp and a second install notch.

17. A universal connector as claimed in any one of the preceding claims, wherein the second configuration of the second connectors includes a second install notch. having a first width that is greater than a second width of a second lead-in ramp and a second mounting surface defined between the second lead-in ramp and the second install notch.

18. A universal connector as claimed in any one of the preceding claims, wherein the first configuration has a generally polygonal shape.

19. A universal connector as claimed in any one of the preceding claims, wherein the second configuration has a generally round shape.

20. A universal connection assembly comprising:
a telescoping slide rail assembly including a stationary slide rail having a pair of flanges operatively coupled adjacent opposing ends thereto;
the flanges having a plurality of apertures formed therein;
a pair of universal connectors each comprising:
a first element operatively coupled to a second element for relative movement;
each of the first and second elements including a base and a pair of opposing arms;
each of the opposing arms including a first connector having a first configuration and a second connector having a second configuration such the first connectors are oriented toward a first side and the second connectors are oriented toward a second side;
the first element further including an elongated projection extending from the first base to a platform and having a pair of legs extending from the platform to define a first receptacle;
the second element further including a pair of legs extending from the second base defining a second receptacle; and
the second receptacle configured to receive the first element pair of legs and a portion of the projection;
wherein one of the first connectors and the second connectors of each universal connector engages one of the at least a pair of the flange apertures to facilitate operative coupling of the telescoping slide rail assembly to a rack.

21. A universal connector as claimed in claim 20, wherein the second element legs include an aperture formed adjacent a distal end thereof in order to operatively couple the second element legs with a fastener that is received by an aperture formed in the projection to define an extent of relative movement.

22. A universal connector as claimed in claim 20 or 21, wherein the first element further includes an indexing structure to facilitate proper orientation of the first connector.

23. A universal connector as claimed in claim 22, wherein the indexing structure is disposed contiguous with the projection, the first connector and the base.

24. A universal connector as claimed in any one of claims 20 to 23, wherein the first element further includes an indexing structure to facilitate proper orientation of the second connector.

25. A universal connector as claimed in claim 24, wherein the indexing structure is disposed contiguous with the projection, the second connector and the base.

26. A universal connector as claimed in any one of claims 20 to 25, wherein the configuration of the first connector facilitates connection with a polygon-shaped aperture.

27. A universal connector as claimed in any one of claims 20 to 26, wherein the configuration of the second connector facilitates connection with a generally round aperture.

28. A universal connector as claimed in any one of claims 20 to 27, further including a biasing element disposed between the platform and the second element base.

29. A universal connector as claimed in any one of claims 20 to 28, wherein the first configuration of the first connectors includes a lead-in ramp.

30. A universal connector as claimed in any one of claims 20 to 29, wherein the first configuration of the first connectors includes a first install notch.

31. A universal connector as claimed in any one of claims 20 to 30, wherein the first configuration of the first connectors includes a first mounting surface defined between a first lead-in ramp and a first install notch.

32. A universal connector as claimed in any one of claims 20 to 31, wherein the first configuration of the first connectors has a first width that is greater than a second width of the second configuration of the second connectors.

33. A universal connector as claimed in any one of claims 20 to 32, wherein the second configuration of the second connectors includes a second lead-in ramp.

34. A universal connector as claimed in any one of claims 20 to 33, wherein the second configuration of the second connectors includes a second install notch.

35. A universal connector as claimed in any one of claims 20 to 34, wherein the second configuration of the second connectors includes a second mounting surface defined between a second lead-in ramp and a second install notch.

36. A universal connector as claimed in any one of claims 20 to 35, wherein the second configuration of the second connectors includes a second install notch having a first width that is greater than a second width of a second lead-in ramp and a second mounting surface defined between the second lead-in ramp and the second install notch.

37. A universal connector as claimed in any one of claims 20 to 36, wherein each flange includes a lock disposed adjacent the universal connector moveable between a first operative position that facilitates installation and removal of the universal connector and a second operative position that facilitates retention of the universal connector.

38. A universal connector as claimed in any one of claims 20 to 37, wherein the first configuration has a generally polygonal shape.

39. A universal connector as claimed in any one of claims 20 to 38, wherein the second configuration has a generally round shape.
